# FASCICULE DE BREVET EUROPEEN

(11) **EP 0 367 689 B1**
(45) Date de publication et mention de la délivrance du brevet: **26.01.1994**
(21) Numéro de dépôt: 89420413.0
(22) Date de dépôt: 25.10.1989
(51) Int. Cl.: H03M 1/10, G01K 7/20, G01K 7/24

(54) **Procédé et dispositif d'étalonnage d'un système comportant un convertisseur analogique-numérique**
Verfahren und Gerät zur Kalibrierung eines einen Analog-Digital-Wandler enthaltenden Systems
Calibration method and device for a system comprising en analog-digital converter

(30) Priorité: 04.11.1988 FR 8815055
(43) Date de publication de la demande: 09.05.1990
(73) Titulaire: MERLIN GERIN, F-38240 Meylan (FR)
(72) Inventeur: Demeyer, Pierre, F-38050 Grenoble Cedex (FR); Barthélémy, Patrick, F-38050 Grenoble Cedex (FR); Martinez, Richard, F-38050 Grenoble Cedex (FR)
(74) Mandataire: Jouvray, Marie-Andrée

(56) Documents cités:
- EP-A- 0 037 259
- US-A- 3 620 082
- US-A- 3 879 724
- John Markus, "Modern Electronic Circuits Reference Manual", McGraw-Hill Book Company, 1980, page 178, circuit "High-Impedance Buffer"

## Description

L'invention concerne un procédé d'étalonnage d'un système comportant un convertisseur analogique-numérique dont l'entrée est reliée à la sortie d'un amplificateur à gain variable, procédé selon lequel on applique à l'entrée de l'amplificateur un signal d'étalonnage d'amplitude prédéterminée, et l'on règle le gain de l'amplificateur pour obtenir en sortie du convertisseur un code numérique correspondant. L'invention concerne également un dispositif pour la mise en oeuvre d'un tel procédé.

De tels systèmes sont très largement utilisés, notamment dans les chaînes de mesure dans lesquelles un capteur fournit des signaux analogiques qui sont convertis en signaux numériques pour permettre un traitement des signaux mesurés au moyen d'un dispositif de traitement numérique.

Un dispositif connu, comportant un convertisseur analogique-numérique, est décrit dans le document EP-A-0.037.259 divulguant une méthode pour réduire la distorsion de quantification. Un autre dispositif, décrit dans le document US-A-3.879.724, comporte une entrée de modulation pour améliorer la précision de la conversion.

La précision finale de la mesure étant directement liée à la précision du convertisseur analogique-numérique, l'invention a pour but un procédé et un dispositif d'étalonnage permettant d'étalonner le système avec une précision supérieure au pas de quantification du convertisseur tout en utilisant un convertisseur standard dont la précision est égale au pas de quantification.

Selon l'invention, ce but est atteint par le fait que le procédé d'étalonnage consiste en outre à appliquer, uniquement pendant l'étalonnage à l'entrée du convertisseur un signal alternatif d'amplitude légèrement inférieure à un pas de quantification du convertisseur et à régler le gain de l'amplificateur de manière à ce que les signaux de sortie du convertisseur soient stables.

La superposition du signal alternatif au signal continu d'étalonnage permet d'augmenter de façon significative la précision de l'étalonnage. En effet, le signal de sortie du convertisseur ne se stabilise que lorsque l'amplitude du signal continu d'étalonnage est située sensiblement au milieu d'un pas de quantification.

Le dispositif pour la mise en oeuvre du procédé selon l'invention est caractérisé en ce qu'il comporte un générateur dont la sortie est destinée à être connectée, uniquement pendant l'étalonnage, à l'entrée du convertisseur et qui produit des signaux de tension alternative d'amplitude légèrement inférieure à un pas de quantification du convertisseur.

Selon un développement de l'invention, le signal alternatif a une fréquence inférieure à 1kHz, de préférence 50Hz.

Des moyens d'affichage numérique connectés à la sortie du convertisseur permettent d'observer facilement les signaux de sortie du convertisseur au cours de l'étalonnage.

D'autres avantages et caractéristiques ressortiront plus clairement de l'exposé qui va suivre d'un mode particulier de réalisation de l'invention, donné à titre d'exemple non limitatif et représenté aux dessins annexés dans lesquels:
La figure 1 représente un dispositif selon l'invention pour l'étalonnage d'une chaîne numérique de mesure de température.
La figure 2 illustre de manière schématique la relation entre les signaux d'entrée et de sortie du convertisseur du dispositif selon la figure 1.

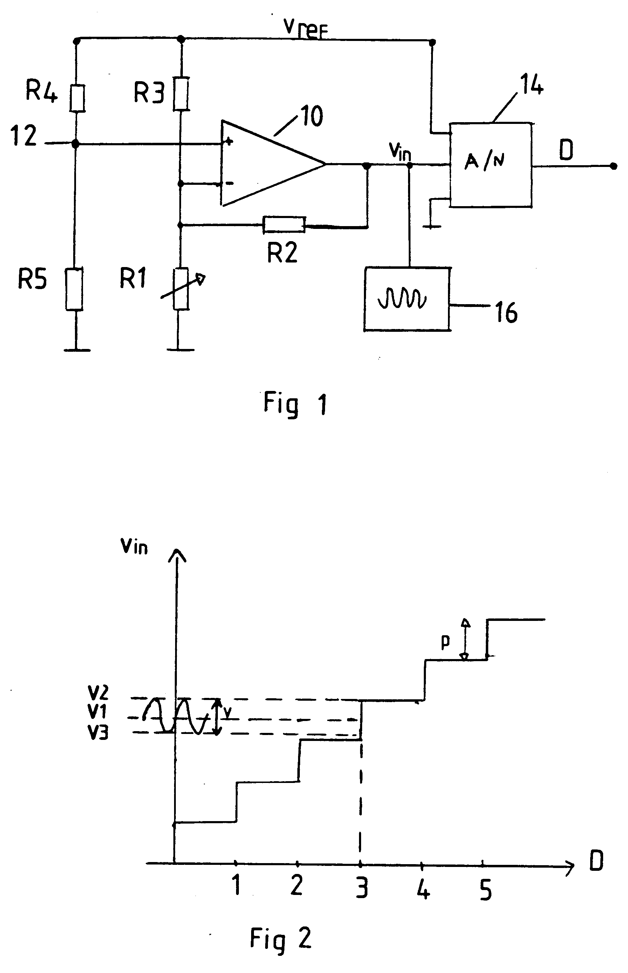

La chaîne de mesure représentée sur la figure 1 comporte un amplificateur à gain variable, constitué par un amplificateur opérationnel 10 dont l'entrée inverseuse est connectée à la masse par une résistance variable R1 et à la sortie par une résistance R2. Cette entrée est également reliée par l'intermédiaire d'une résistance R3 à une tension de référence Vref. L'entrée non inverseuse de l'amplificateur est connectée à la borne d'entrée 12 de la chaîne de mesure et, par une résistance R4, à la tension de référence.

En fonctionnement normal de la chaîne de mesure, un capteur de température (non représenté) est connecté entre la borne d'entrée 12 et la masse.

La sortie de l'amplificateur est connectée à l'entrée d'un convertisseur analogique-numérique 14 dont l'entrée référence est reliée à la tension de référence.

La sortie du convertisseur 14 peut être connectée à un dispositif de traitement numérique à microprocesseur (non représenté) qui peut être intégré dans le même boîtier que le capteur, l'amplificateur et le convertisseur, formant ainsi un module capteur de température pouvant éventuellement être lui-même connecté à un réseau de transmission de données permettant une gestion centralisée.

Pour étalonner la chaîne de mesure, une résistance d'étalonnage R5 est connectée, à la place du capteur de température, entre la borne d'entrée 12 et la masse. Cette résistance R5 a une valeur connue avec précision, par exemple à 0,01%, simulant la valeur de la résistance du capteur à une température prédéterminée, par exemple à 20°C.

La tension de référence Vref et la valeur de la résistance R4 étant connues, la tension appliquée à la borne d'entrée 12 a une amplitude prédéterminée, simulant le signal d'entrée appliqué à la chaîne de mesure lorsque la température est de 20°C.

En modifiant le gain de l'amplificateur, on modifie les données D apparaissant en sortie du convertisseur. Le règlage du gain est effectué de manière à obtenir des données D correspondant à un code présélectionné représentatif de la température d'étalonnage choisie, par exemple 20°C.

Si l'on utilise un convertisseur analogique-numérique standard fournissant un signal codé D de 8 bits, la précision maximale ainsi obtenue correspond à un pas de quantification, soit 1/256ème de la valeur maximale du signal Vin d'entrée du convertisseur (associée à 8 bits).

Selon l'invention on améliore de façon significative cette précision d'étalonnage en superposant au signal continu de sortie de l'amplificateur 10 un signal alternatif fourni par un générateur de tension alternative 16.

De cette manière le signal Vin appliqué à l'entrée du convertisseur 14 au cours de l'étalonnage est constitué par la superposition d'un signal continu d'amplitude V1 et d'un signal alternatif dont l'amplitude v est légèrement inférieure à un pas de quantification du convertisseur (figure 2).

On a illustré sur la figure 2, la relation entre les signaux Vin d'entrée du convertisseur et les données D de sortie du convertisseur codées de façon arbitraire de 1 à 5 sur la figure. Le code 3 des données de sortie D est associé à un signal Vin d'entrée d'amplitude V1 ± p/2, p étant le pas de quantification du convertisseur.

Lors de l'étalonnage, en l'absence de signal alternatif, il n'est pas possible de régler le gain de l'amplificateur avec une précision supérieure à la précision du convertisseur. En effet, le signal de données D obtenu en sortie du convertisseur reste le même pour un signal de sortie de l'amplificateur à gain réglable ayant une valeur quelconque comprise entre V1-p/2 et V1+p/2.

En superposant au signal de sortie de l'amplificateur le signal alternatif d'amplitude v, le signal Vin d'entrée du convertisseur varie, pour un même réglage du gain de l'amplificateur, entre V1+v/2 et V1-v/2. Si l'amplitude du signal continu de sortie de l'amplificateur est égale à V1, valeur située au centre du pas de quantification associé au code choisi (3 sur la figure), alors le signal Vin varie entre V3 et V2, comme représenté sur la figure 2, toutes ces valeurs étant associées au même code 3. Par contre, si l'amplitude du signal continu de sortie de l'amplificateur est supérieure à V1, alors la valeur supérieure de Vin obtenue par superposition du signal alternatif correspondra au code 4, tandis que sa valeur inférieure correspondra au code 3. De même, si cette amplitude est inférieure à V1, alors la valeur inférieure de Vin correspondra au code 2, tandis que sa valeur supérieure correspondra au code 3.

Les signaux de données D oscilleront donc entre le code prédéterminé correspondant à la tension d'étalonnage et le code supérieur ou inférieur tant que le réglage du gain de l'amplificateur sera tel que l'amplitude du signal continu de sortie de l'amplificateur, bien que comprise entre V1-p/2 et V1+p/2, ne sera pas sensiblement égale à V1.

Afin de permettre un réglage facile du gain de l'amplificateur, des moyens d'observation des données D sont connectés en sortie du convertisseur. Ces moyens sont par exemple constitués par un dispositif d'affichage numérique (non représenté) permettant d'une part de vérifier si le code correspond bien au code prédéterminé choisi et si le réglage du gain est tel que la valeur affichée n'oscille pas d'un code au suivant. Le clignotement des données affichées indique donc que le réglage optimum n'est pas encore atteint.

Pour permettre l'observation des données, la fréquence du signal alternatif ne doit pas être trop élevée, en pratique inférieure à 1kHz. Dans un mode de réalisation préféré on utilise un générateur 16 à la fréquence du réseau (soit 50Hz).

Bien que l'invention ait été décrite en relation avec une chaîne de mesure de température, il est évident qu'elle n'est pas limitée à un tel système mais est applicable de la même manière pour l'étalonnage de tout système comportant en série un amplificateur à gain variable, destiné à recevoir des signaux à mesurer, et un convertisseur analogique-numérique.

## Revendications

1. Procédé d'étalonnage d'un système comportant un convertisseur analogique-numérique (14) dont l'entrée est reliée à la sortie d'un amplificateur à gain variable (10,R1,R2), procédé selon lequel on applique à l'entrée de l'amplificateur un signal d'étalonnage d'amplitude prédéterminée, et l'on règle le gain de l'amplificateur pour obtenir en sortie du convertisseur un code numérique correspondant, procédé caractérisé en ce qu'il consiste en outre à appliquer, uniquement pendant l'étalonnage, à l'entrée du convertisseur un signal alternatif d'amplitude (v) légèrement inférieur à un pas de quantification (p) du convertisseur et à régler le gain de l' amplificateur de manière à ce que les signaux (D) de sortie du convertisseur soient stables.

2. Procédé selon la revendication 1, caractérisé en ce que le signal alternatif a une fréquence inférieure à 1kHz.

3. Procédé selon la revendication 2 caractérisé en ce que le signal alternatif est un signal de 50Hz.

4. Dispositif pour la mise en oeuvre du procédé selon l'une quelconque des revendications 1 à 3 pour l'étalonnage d'un système comportant un convertisseur analogique-numérique (14) dont l'entrée est reliée à la sortie d'un amplificateur à gain variable (10,R1,R2) dont l'entrée est destinée à recevoir un signal analogique à mesurer ou un signal d'étalonnage d'amplitude prédéterminée, dispositif comportant des moyens pour appliquer un signal d'étalonnage d'amplitude prédéterminée à l'entrée de l'amplificateur et caractérisé en ce qu'il comporte un générateur (16) dont la sortie est destinée à être connectée, uniquement pendant l'étalonnage, à l'entrée du convertisseur et qui produit des signaux de tension alternative d'amplitude (v) légèrement inférieure à un pas de quantification (p) du convertisseur.

5. Dispositif selon la revendication 4, caractérisé en ce qu'il comporte des moyens d'affichage numérique connectés à la sortie du convertisseur.

6. Dispositif selon l'une des revendications 4 et 5, dans lequel ledit système est constitué par une chaîne numérique de mesure de température, dans laquelle un capteur de température est destiné à être connecté à l'entrée de l'amplificateur et alimenté par une source de tension d'amplitude prédéterminée dispositif caractérisé en ce qu'une résistance d'étalonnage alimentée par ladite source de tension est connectée à l'entrée de l'amplificateur à la place du capteur pour effectuer l'étalonnage de la chaîne de mesure.

## Claims

1. A process for calibrating a system comprising an analog-to-digital converter (14) whose input is connected to the output of a variable gain amplifier (10,R1,R2), a process whereby a calibration signal of predetermined amplitude is applied to the amplifier input, and the amplifier gain is adjusted to obtain a corresponding digital code on output of the converter, a process characterized in that it consists in addition in applying to the converter input, during calibration only, an AC signal of an amplitude (v) slightly lower than a quantification step (p) of the converter and in adjusting the amplifier gain in such a way that the converter output signals (D) are stable.

2. The process according to claim 1, characterized in that the AC signal has a frequency of less than 1kHz.

3. The process according to claim 2, characterized in that the AC signal is a 50Hz signal.

4. A device for implementing the process according to any one of the claims 1 to 3 for calibration of a system comprising an analog-to-digital converter (14) whose input is connected to the output of a variable gain amplifier (10,R1,R2) whose input is designed to receive an analog signal to be measured or a calibration signal of predetermined amplitude, a device comprising means for applying a calibration signal of predetermined amplitude to the amplifier input and characterized in that it comprises a generator (16) whose output is designed to be connected, during calibration only, to the converter input and which produces AC voltage signals of an amplitude (v) slightly lower than a quantification step (p) of the converter.

5. The device according to claim 4, characterized in that it comprises digital display means connected to the converter output.

6. The device according to one of the claims 4 and 5, wherein said system is formed by a digital temperature measuring channel, wherein a temperature probe is designed to be connected to the amplifier input and supplied by a voltage source of predetermined amplitude, a device characterized in that a calibration resistance supplied by said voltage source is connected to the amplifier input instead of the probe to perform calibration of the measuring channel.

## Patentansprüche

1. Verfahren zum Abgleich eines Systems mit Analog-Digital-Umsetzer (14), dessen Eingang mit dem Ausgang eines Verstärkers mit veränderbarem Verstärkungsfaktor (10, R1, R2) verbunden ist, wobei ein Abgleichsignal mit festgelegter Amplitude an den Vorstärkereingang gelegt und der Verstärkungsfaktor des Verstärkers so geregelt wird, daß am Ausgang des Umsetzers ein entsprechendes Digitalsignal zur Verfügung steht, dadurch gekennzeichnet, daß das Verfahren des weiteren darin besteht, den Eingang des Umsetzers ausschließlich während der Abgleichphase mit einem Wechselspannungssignal zu beaufschlagen, dessen Amplitude (v) geringfügig unter einem Zählschritt (p) des Umsetzers liegt, und den Verstärkungsfaktor des Verstärkers so auszuregeln, daß die Ausgangssignale (D) des Umsetzers stabil sind.

2. Verfahren nach Anspruch 1, dadurch gekennzeichnet, daß die Frequenz des Wechselspannungssignals unter 1 kHz liegt.

3. Verfahren nach Anspruch 2, dadurch gekennzeichnet, daß das Wechselspannungssignal ein 50-Hz-Signal ist.

4. Schaltungsanordnung zur Durchführung des Verfahrens gemäß irgendeinem der Ansprüche 1 bis 3 zum Abgleich eines Systems mit einem Analog-Digital-Umsetzer (14), dessen Eingang mit dem Ausgang eines Verstärkers mit veränderbarem Verstärkungsfaktor (10, R1, R2) verbunden ist, dessen Eingang dazu dient, mit einem analogen Meßsignal oder einem Abgleichsignal mit festgelegter Amplitude beaufschlagt zu werden, wobei die Schaltungsanordnung Mittel zur Beaufschlagung des Verstärkereingangs mit einem Abgleichsignal mit festgelegter Amplitude aufweist und dadurch gekennzeichnet ist, daß sie einen Generator (16) umfaßt, dessen Ausgang dazu dient, ausschließlich während der Abgleichphase mit dem Eingang des Umsetzers verbunden zu werden, und der Wechselspannungssignale mit einer Amplitude (v) erzeugt, die geringfügig unter einem Zählschritt (p) des Umsetzers liegt.

5. Schaltungsanordnung nach Anspruch 4, dadurch gekennzeichnet, daß sie an den Ausgang des Umsetzers angeschlossene digitale Anzeigemittel aufweist.

6. Schaltungsanordnung nach Anspruch 4 oder 5, dadurch gekennzeichnet, daß das genannte System aus einem digitalen Temperatur-Meßkreis besteht, in dem ein Temperaturfühler dazu dient, an den Eingang des Verstärkers angeschlossen zu werden und über eine Spannungsquelle mit festgelegter Amplitude versorgt wird, dadurch gekennzeichnet, daß ein über die genannte Spannungsquelle versorgter Abgleichwiderstand zur Durchführung des Abgleichs des Meßkreises anstelle des Temperaturfühlers an den Eingang des Verstärkers angeschlossen wird.
